Europäisches Patentamt

European Patent Office

Office européen des brevets

(11) Publication number: **0 074 859**
**A2**

# EUROPEAN PATENT APPLICATION

(21) Application number: **82304878.0**

(51) Int. Cl.³: **H 03 K 13/05**

(22) Date of filing: **16.09.82**

(30) Priority: **16.09.81 US 302840**

(43) Date of publication of application:
**23.03.83 Bulletin 83/12**

(84) Designated Contracting States:
**CH DE FR GB IT LI SE**

(71) Applicant: BROOKTREE CORPORATION
Route 1 box N3
Del Mar California 92014(US)

(72) Inventor: Katzenstein, Henry S.
739 Brooktree Road
Pacific Palisades California 90272(US)

(74) Representative: Pears, David Ashley et al,
REDDIE & GROSE 16 Theobalds Road
London WC1X 8PL(GB)

(54) Digital-to-analog converter.

(57) A plurality of transistor switches (22) have open and closed states and substantially identical characteristics. The switches are arranged in groups (24, 26, 28, 30, 32) each associated with an individual digital signal (12, 14, 16, 18, 20). The number of switches in each group is directly related to the weighted significance of the associated digital signal. The transistors in each group may be distributed throughout an integrated circuit ship to average their characteristics. When a group of transistors are conductive, current flows in an output line (34). The currents are summed in the output line. The current through additional transistors on the chip may be compared with a reference current. The error signal is used to control the voltage source (42).

Fig. 1

# DIGITAL-TO-ANALOG CONVERTER

This invention relates to apparatus for converting data between a digital form and an analog form. More particularly, the invention relates to apparatus which provides such conversion in a simple and reliable manner with minimal errors and with high power and at high frequencies.

Various types of equipment receive information in analog form. Such equipment includes process control equipment, measuring instruments, communication equipment and a wide variety of other types of equipment. Digital computers and data processing systems convert this analog information to digital form for processing in the computer or the data processing equipment. After the analog information has been converted to digital information and has been processed, the output information from the digital computer or the data processing equipment is often converted to analog form. By converting the output information to analog form, the user can assimilate the information in ways which would be difficult or impossible if the information continued to be in digital form.

A good example of the conversions discussed in the previous paragraph is in the recording and reproduction of music. The music is produced in analog form. It is converted to digital form by recently developed data processing techniques and is recorded on a medium such as a tape or a disc. When the music is to be reproduced, it is converted again to analog form because this is the form which is necessary to operate sound transducers to give meaning to the listener.

As digital computers and data processing equipment have become widespread throughout industry and the office and have even become common in the home, the need for inexpensive, simple and reliable apparatus for converting information between analog and digital form has become of increasing concern. A considerable effort has been devoted over a period of several decades to provide converting apparatus which is accurate, stable, simple. inexpensive and reliable. In spite of such efforts, the converting apparatus now in use does not meet all of such criteria.

The converting apparatus now in use also has other problems of long standing. For example, the converting apparatus now in use may not be monotonic unless it is quite expensive and complex. By "monotonic" is meant that digital information of progressively increasing value is converted to analog information of progressively increasing value without any decrease in the analog value as the digital value progressively increases. The converting apparatus now in use also has relatively high differential and integral non-linearities unless the apparatus is quite expensive and complex. Integral non-linearities result from errors accumulated in a conversion between analog and digital values over a wide range of such values. Differential nonlinearities result from errors produced in a conversion between analog and digital values over a relatively narrow range of such values.

This invention provides apparatus for converting between digital and analog values on a monotonic basis, particularly when elements of high precision are used. The apparatus of this invention provides such a conversion with relatively small differential and integral non-linearities, particularly when the elements included in the invention are formed with high precision and there are a considerable number of elements to provide an averaging of errors. The apparatus of this invention is simple, inexpensive and reliable. It is able to operate with relatively high precision at high power. As a result, the converting apparatus of this invention is capable of being used in areas not available for the converters of the prior art. For example, the apparatus of this invention is able to convert aural information in analog form into information in digital form and to convert the digital information back to the aural information in analog form by serving both as a converter and an amplifier.

The apparatus of this invention also has other advantages of some importance. For example, it is relatively free of the effects of aging and changes in temperature. It is also capable of providing accurate and reliable conversions between analog and digital values at high frequencies with minimal error.

The invention is defined in Claim 1 below.

In one embodiment of the invention, a plurality of switches are provided with open and closed states and with substantially identical characteristics. The switches operate in the closed state to provide a current of a particular value. The switches are arranged electrically in groups each associated with an individual signal in a plurality to provide a digital representation of the value of a parameter. The number of switches in each group is directly related to the weighted significance of the associated digital signal. The switches may constitute transistors disposed on an integrated circuit chip. The transistors in each group may be spaced throughout the chip to average their characteristics.

Each digital signal in the plurality is introduced to an individual one of the groups of transistors, and particularly to input terminals in the transistors, to control the conductivity of the transistors in the group. When the transistors are conductive, current flows through the transistors such as to an output terminal. The currents in the output terminals of the transistors are summed in an output line.

Additional transistors may be provided on the chip in spaced relationship to average their characteristics. Current flows through the additional transistors from a voltage source. This current is compared with a reference current. Any differences in such comparison are used to adjust the voltage from the voltage source. In this way, the output current from the transistors is adjusted to have an amplitude corresponding to the digital input to the transistors.

The transistors on the chip may be disposed in modules each constructed to indicate a particular number of digits. The modules are constructed to be connected electrically so as to increase the number of digits being represented.

An analog signal may be provided. Means may be included to vary the digital signals to make the current on the output line coincide with the analog signal. In this way, the digital signals indicate digitally the analog values represented by the analog signals.

In the drawings:

Figure 1 is a schematic diagram of a converter constituting one embodiment of the invention for converting between digital and analog values;

Figure 2 is a schematic diagram of an integrated circuit chip on which the converter shown in Figure 1 may be disposed;

Figure 3 is a schematic diagram of an integrated circuit chip on which a plurality of converters such as shown in Figure 1 may be disposed in modular form;

Figure 4 is a schematic diagram showing the spaced disposition on an integrated circuit chip of different transistors shown in Figure 1;

Figure 5 is a block diagram of apparatus included in the converter of Figure 1 to regulate the output current from the converter; and

Figure 6 is a block diagram showing an analog-to-digital converter which incorporates the apparatus of Figure 1.

In one embodiment of the invention, a digital-to-analog converter generally indicated at 10 is provided. The converter 10 receives digital signals on a plurality of input lines 12, 14, 16, 18 and 20. The signals on the lines preferably represent information in binary form. For example, the signals on the lines 12, 14, 16, 18 and 20 may respectively represent information of progressive binary significance. Illustratively, a binary "1" may be represented by a signal of high amplitude and a binary "0" may be represented by a signal of low amplitude. Although only five digits are shown, it will be appreciated that any particular number of digits may be used. Furthermore, although the information is preferably in binary form, other digital codes may be used.

The information on the lines 12, 14, 16, 18 and 20 are introduced to switches generally indicated at 22. One switch 24 may be responsive to the information on the line 12. Two switches 26a and 26b may be responsive to the information on the line 14. Four switches 28a, 28b, 28c and 28d may be responsive to the information on the line 16. Similarly, eight switches 30a through 30h may be responsive to the signals on the line 18 and sixteen switches 32a through 32p may be responsive to the signals on the line 20.

For the purposes of the specification and the claims, each of the switches 24, 26, 28, 30 and 32 may be considered as an electrical group. The switches in the different electrical groups preferably have substantially identical characteristics. Each of the switches may have open and closed states. The switches may be triggered to the closed states upon the introduction to the switches of a signal representing a binary "1". The switches may be in the open state upon the introduction to the switches of a signal representing a binary "0".

The switches may be considered as current-limiting devices having two (2) states of operation. In one state of each switch, no current flows through the switch. In the other state of each switch, a limited current flows through the switch because of the characteristics of the switch.

The switches 24, 26a and 26b, 28a-28d, 30a-30h and 32a-32p may be any suitable type of transistor and may be made from any suitable material. For example, they may be MOS field effect transistors of either the p type or n type or thin film transistors or NPN or PNP "current mirror" bi-polar transistors or channel junction field effect transistors of either the n or p type. As previously described, the transistors may be provided with conductive and nonconductive states and may be provided with characteristics providing for the flow of a substantially constant current in the conductive state of the transistors. The transistors may be further provided with resistive characteristics in the conductive states for controlling the flow of current through the transistors within narrow limits even with changes in the voltages applied to the switches.

The signals on the lines 12,14,16,18 and 20 are preferably introduced to the gates or bases of the transistors. The sources or emitters of the transistors may be connected to an output line 34. The drains or collectors of the transistors may be connected between the drains or collectors of the transistors and the voltage

source 42. All of the resistors may have substantially equal values. The resistors may be formed on integrated circuit chips by well known techniques such as impurities in the silicon on the chips or variations in the thickness of the silicon on the chips.

As will be seen, the current flowing the output line 34 is dependent upon the number of transistors which are conductive at any instant. The number of transistors conductive at any instant is directly related to the digital values represented by the signals on the input lines 12, 14, 16, 18 and 20. For example, when the lines 12 and 16 have signals of high amplitude representing digital values of "1", the transistor 24 and the transistors 28a, 28b, 28c and 28d are conductive so that the current on the output line 34 has an analog value of "5". Similarly, when the lines 14 and 18 have signals of high amplitude representing digital values of "1", the transistors 26a and 26b and the transistors of 30 a through 30h are conductive to represent a decimal value of "10".

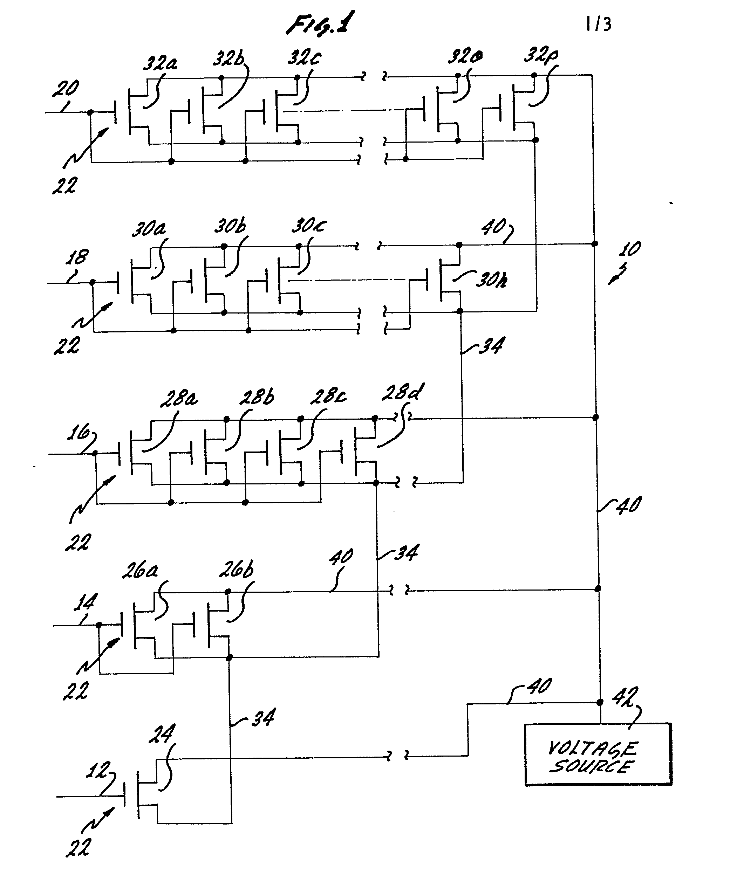

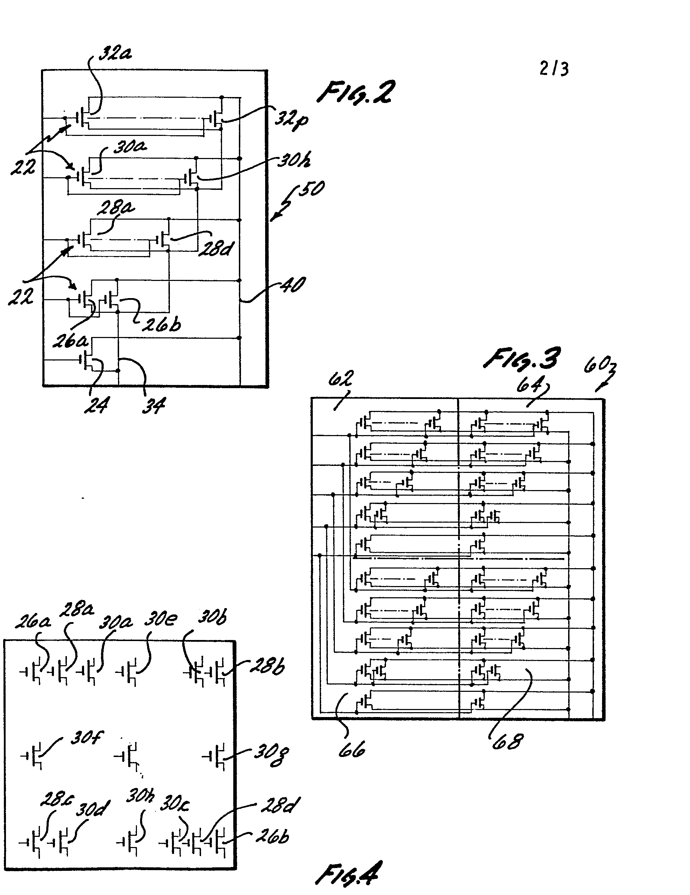

The apparatus shown in Figure 1 and described above may be incorporated on a chip generally indicated at 50 in Figure 2. Such incorporation may be provided by large-scale integration (LSI) or very large-scale integration (VLSI) techniques. In this way, the apparatus is self-contained. Furthermore, since all of the transistors are formed simultaneously on the chip and the chip is quite small, the transistors have substantially identical characteristics. This tends to assure that the current on the output line 34 represents accurately in analog form the digital information represented by the signals on the lines 12, 14, 16, 18 and 20.

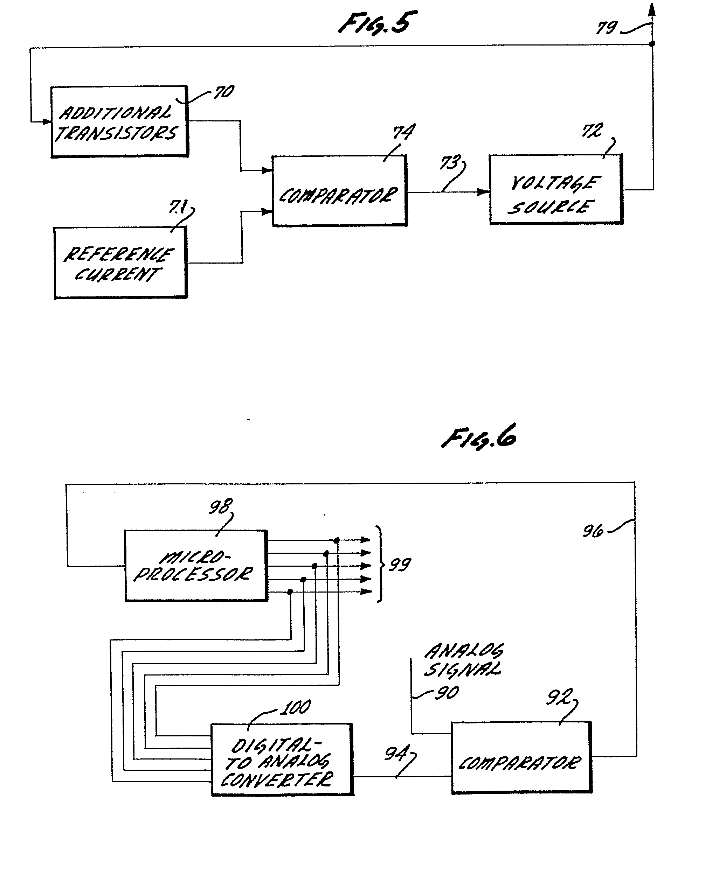

Actually, a plurality of modules may be provided on a single chip generally indicated at 60 in Figure 3. The modules are indicated schematically at 62, 64, 66 and 68 in Figure 3. Each of the modules may be constructed in a manner similar to that shown in Figure 1. In this way, an increased number of digits may be provided by combining the modules 62 and 64 to provide a single output from the two modules. By providing such a combination, the modules 62 and 64 provide an output representing six (6) binary digits rather than only five (5) binary digits such as provided by either of the modules 62 or 64 when acting alone.

Similarly, the modules 62, 64, 66 and 68 can be combined to provide an output representing seven (7) binary digits. Since the modules 62, 64, 66 and 68 are only representative, it will be appreciated that any desired number of modules can be provided on a single chip dependent upon the packing of circuitry available on the chip. Actually, present indications are that circuitry providing a conversion as high as sixteen (16) binary digits can be produced on a chip by large-scale integration (LSI) or very large-scale integration (VLSI) techniques.

The provision of modules on a single chip also offers other advantages. For example, if tests indicate that the module 66 is defective, the modules 62 and 64 can still be used in combination to provide a digital significance of

0074859

six (6) binary bits. This module can be sold to a customer who is interested only in an accuracy of six (6) binary bits rather than seven (7) binary bits. In this way, a defective module does not necessarily mean a destruction of the chip but indicates only that the chip may have to be downgraded in the accuracy of its conversion of digital information to analog information.

In order to increase the accuracy of the output current on the output line 34, the different transistors in each group may be disposed in a spaced arrangement such as shown in Figure 4. For example, the transistors 26a and 26b may be disposed in opposite diagonal corners. Similarly, the transistors 28a, 28b, 28c and 28d may be disposed in the four corners of the chip. The transistors 30a through 30h may be disposed in the four corners and may also be disposed at intermediate positions between the opposite corners.

By disposing the transistors in each group in a spaced relationship, any deviations in the characteristics of the chip at isolated positions on the chip can be averaged in the transistors of each group so that the accuracy of the output current on the line 34 is enhanced. It will be appreciated that the arrangement shown in Figure 4 is only by way of example and that the disposition of the transistors may be provided in any suitably spaced relationship to obtain the desired averaging effect.

Additional transistors generally indicated at 70 in Figure 5 may also be provided on the chip 50 in Figure 2 or in the modules on the chip 60 in Figure 3. These additional transistors have characteristics substantially identical to the characteristics of the transistors in Figure 1.

A current flows through the additional transistors 70 from a voltage source 72 corresponding to the voltage source 42 in Figure 1. The current flowing through the additional transistors 70 is compared in a comparator 74 with a reference current from a source 71. The polarity and the magnitude of a signal produced by the comparator 74 as a result of this comparison is indicated by the signal on a line 73. The signal on the line 73 causes the voltage from the source 72 to be adjusted so that the current from the additional transistors and and the reference current are equal, this adjusted voltage is introduced to the transistors in Figure 1 to energize the transistors. This is indicated by an arrow 79 in Figure 5.

Any number of transistors may be used as the additional transistors 70 and may be disposed on the chip 50 in Figure 2 or in the modules 62, 64, 66 and 68 on the chip 60 in Figure 3. The additional transistors may be spaced throughout the chip 50 or throughout each of the modules on the chip 60 in a manner similar to that described for the transistors in Figure 1. As will be appreciated, a group of additional transistors 70 may be individually associated with each of the modules 62, 64, 66 and 68. In this way, the currents through the additional transistors 70 are averaged to compensate for deviations in the characteristics of the additional transistors as a result of localized deviations in the characteristics of the material on the chip 50 in Figure 2 or the chip 60 in Figure 3.

The apparatus shown in Figures 1 through 5 and described above provides a conversion of digital signals to an analog representation. The apparatus shown in Figure 5 may also be used in a system such as shown in Figure 6 to provide a conversion of analog information to a plurality of digital signals representing the analog information.

In the embodiment shown in Figure 6, an analog signal is provided on a line 90. This analog signal is to be converted to digital form. This analog signal is compared in a comparator 92 with the analog signal on a line 94 which corresponds to the output line 34 in the converter shown in Figure 1. The results of the comparison from the comparator 92 are introduced through a line 96 to a data processor such as a microprocessor 98. The microprocessor 98 processes the information represented by the signal on the line 96 and introduces signals to the input terminals of a digital-to-analog converter 100 corresponding to the converter shown in Figure 1. The signals introduced to the digital-to-analog converter 100 cause the converter 100 to provide an analog signal on the line 94 corresponding in characteristics to the analog signal on the line 90. When the analog signal on the line 94 corresonds in characteristics to the analog signal on the line 90, the output signals on lines 99 from the microprocessor constitute the digital signals which are introduced to the analog converter of Figure 1 to obtain a conversion into a corresponding analog signal.

The apparatus described above has certain important advantages. It provides a conversion between digital and analog values at a relatively fast rate because the conversion results from the opening and closing of switches. The conversion is accurate and reliable, particularly when the converter is disposed on an integrated circuit chip. This results from the fact that the chip is quite small and the chip has substantially uniform characteristics throughout its surface area. For example, the chip may have a surface area less than one tenth inch (1/10") square. Furthermore, the accuracy of the conversion can be enhanced by disposing the switches in each group in a spaced relationship throughout the surface area of the chip.

The converter of this invention also has other advantages of some importance, particularly when the transistors on the chip are formed with a high precision and a minimal error in operation and particularly when a large number of transistors are provided on the integrated circuit chip. For example, the converter may be monotonic under such circumstances. This results from the fact that the conversion to analog form of digital signals of progressively increasing value is obtained by producing a closure of increased numbers of switches of high precision and minimal error in operation, with the resultant flow of current through the increased numbers of switches. Furthermore, by producing closures of such switches to convert digital information to an analog form, errors resulting from differential and integral non-linearities may be relatively low.

There are other important advantages to the converter of this invention. For example, the converter of this invention is quite small, particularly in relation to the converters of the prior art. This is particularly true when the converters of this invention are compared with converters providing a comparable accuracy in the prior art. The converters of this invention are also quite inexpensive compared to converters of the prior art. This results in part from the production of the converter on a single integrated circuit chip.

The apparatus of this invention also offers the advantage of providing a high current amplification. This results from the fact that the amount of current delivered at the output lead, such as the lead 34 in Figure 1, can be adjusted by varying the number of switches in each stage. For example, the output current can be increased by increasing the number of switches in each stage. As a result of its ability to provide large current amplification, the converter of this invention can be considered to provide current amplification at the same time that it provides a conversion. This may be important in such applications as conversion of aural information such as sound. The invention accordingly has particular utility in the recently developed techniques of digital recording and reproduction of sound.

The apparatus of this invention is easily adaptable to provide for an addition of digits to increase its accuracy. This results in part from the modular construction of the apparatus such as shown in Figure 3. The apparatus also maintains its accuracy as it ages. This is particularly true when the apparatus is disposed on an integrated circuit chip such as shown in Figure 2 or Figure 3. The apparatus maintains its accuracy as it ages because the chip is essentially homogeneous in construction. As a result, all of the switches on the chip age in substantially identical relationships. The disposition of the different switches in spaced relationship on the chip also facilitates an aging in which the accuracy is maintained.

The converter of this invention is also substantially free of the effects of temperature for substantially the same reasons as discussed above with respect to aging.

This is particularly true when the current on the output terminal is regulated as shown in Figure 5 and as discussed above. Such avoidance in the integrated circuit chip of the effects of temperature variations also results from the fact that the distribution of the switches in each group throughout the surface area of the chip (such as shown in Figure 4) prevents the temperature of the chip from becoming excessive at any localized areas.

Although this application has been disclosed and illustrated with reference to particular applications, the principles involved are susceptible of numerous other applications which will be apparent to persons skilled in the art. The invention is, therefore, to be limited only as indicated by the scope of the appended claims.

- 18 -

CLAIMS

1.      A digital-to-analog converter comprising switches controlled by digital signals having different numerical weights, characterised in that the switches (22) are in groups (24, 26, 28, 30, 32), each group containing a number of switches (22) related to the weight of a corresponding one of the digital signals (12, 14, 16, 18, 20) and the switches providing a cumulative current in an output line (34) determined by which groups of switches are rendered conductive by the corresponding digital signals.

2.      A digital-to-analog converter according to claim 1, characterised in that the switches (22) are formed on an integrated circuit chip (50).

3.      A digital-to-analog converter according to claim 2, characterised in that the switches (22) of each group are distributed over the chip area so as to render heat dissipation substantially uniform throughout the chip area.

4.      A digital-to-analog converter according to claim 2 or 3, characterised in that the chip (60) carries a plurality of modules (62, 64, 66, 68), each constituting a converter as defined in claim 1, the modules being usable together to extend the number of digits handled by the converter.

5.      A digital-to-analog converter according to any of claims 1 to 4, characterised by a plurality of additional switches (70) acting as reference switches, means (74) comparing the current passed by the reference switches with a reference current (71) and for adjusting (73) the voltage of a source (72) connected to the groups of switches (22) and the additional switches (70).

6.      A digital-to-analog converter according to claims 3 and 5, characterised in that the additional switches (70) are also distributed over the chip area among the switches (22) of the said groups.

7.      A digital-to-analog converter according to any of claims 1 to 6, characterised in that the switches (22) are transistor switches.

8.      A digital-to-analog converter according to claim 8, characterised in that the digital signals are applied to the gates or bases of the transistors (22), the sources or emitters of the transistors are connected to the output line (34) and the drains or collectors of the transistors are connected to a voltage source (42 or 72).

9.      An analog-to-digital converter comprising a digital-to-analog converter (100) according to any of claims 1 to 8, characterised by means (92) for comparing an input analog signal (90) with the signal (94) from the digital-to-analog converter (100) and means (98) responsive to a resultant difference signal (96) to adjust the digital signals which are provided on output lines (99) and to the inputs of the digital-to-analog converter (100).

Fig.1

0074859

1/3

0074859

2/3

FIG.2

FIG.3

FIG.4

FIG.5

FIG.6